# EUROPÄISCHE PATENTSCHRIFT

(11) **EP 2 298 052 B1**
(45) Veröffentlichungstag und Bekanntmachung des Hinweises auf die Patenterteilung: **29.02.2012**
(21) Anmeldenummer: 09769147.1
(22) Anmeldetag: 16.06.2009
(51) Int. Cl.: H05K 13/04

(54) **ELEKTRONISCHES BAUELEMENT**
ELECTRONIC COMPONENT
COMPOSANT ÉLECTRONIQUE

(30) Priorität: 24.06.2008 DE 102008030631
(43) Veröffentlichungstag der Anmeldung: 23.03.2011
(73) Patentinhaber: Würth Elektronik IBE GmbH, 94136 Thyrnau (DE)
(72) Erfinder: KONZ, Oliver, 74532 Ilshofen (DE)
(74) Vertreter: Patentanwälte Ruff, Wilhelm, Beier, Dauster & Partner
(86) Internationale Anmeldenummer: PCT/EP2009/057433
(87) Internationale Veröffentlichungsnummer: WO 2009/156298

(56) Entgegenhaltungen:
- EP-A- 0 548 583
- EP-A- 0 716 483
- DE-A1-102005 022 927
- DE-U1- 29 804 135

## Beschreibung

Die Erfindung betrifft die Anbringung elektronischer Bauteile an Leiterplatten. Elektronische Bauteile werden in automatisierten Vorgängen an Leiterplatten befestigt, beispielsweise in SMD. Um sie an die richtige Stelle zu bringen, werden Greifer verwendet, die an den Bauteilen durch Saugwirkung angreifen. Zur Bewegung an ihre richtige Position werden häufig hohe Geschwindigkeiten mit dabei auftretenden Beschleunigungen verwendet. Manche elektronische Bauteile, beispielsweise Spulen, haben aber keine Stellen, an denen ein Greifer mit Saugwirkung angreifen kann.

Nun ist es bereits vorgeschlagen worden (DE 10 2005 022927 A1), an einem elektronischen Bauelement, beispielsweise einer Spule, ein aus Kunststoff bestehendes Halteelement anzuspritzen, das eine Angriffsstelle für einen Greifer bildet.

Weiterhin ist eine Stabkerndrossel bekannt, bei der auf die Wicklung eine elastische Klammer aus Kunststoff aufgesetzt ist, die sich in Längsrichtung der Drossel über den größten Teil der Wicklung erstreckt. Die Klammer weist eine glatte Innenseite und an ihrer Außenseite eine ebene Angriffsfläche für einen Greifer auf (DE 29804135 U1). Eine Sicherung in Längsrichtung der Drossel zwischen der Klammer und der Drossel ist nicht vorhanden.

Ebenfalls bekannt ist ein Deckel zum Transport von elektrischen Verbindern mithilfe von Vakuum (EP 0716483 A2), der mit zwei Paaren nachgiebiger Beine an der Innenseite und Außenseite von Wänden des festzuhaltenden Bauteils angreift.

Der Erfindung liegt die Aufgabe zu Grunde, eine weitere Möglichkeit zu schaffen, ein elektronisches Bauelement so ausbilden zu können, dass es sich für die automatische Bestückung von Leiterplatten mithilfe von Greifern besonders eignet.

Zur Lösung dieser Aufgabe schlägt die Erfindung ein elektronisches Bauelement mit den im Anspruch 1 genannten Merkmalen vor. Weiterbildungen der Erfindung sind Gegenstand von Unteransprüchen.

Das Halteelement ermöglicht es auch bei solchen elektronischen Bauteilen, die keine definierte Angriffsstelle für einen Greifer aufweisen, diese durch Greifer positionieren zu lassen. Der Greifer greift dabei an der Angriffsstelle des Halteelements an.

Insbesondere kann vorgesehen sein, dass das Halteelement als Clip ausgebildet ist, der sich auf das elektronische Bauteil aufschnappen lässt.

Als Angriffsstelle für den Greifer, der üblicherweise mit Saugwirkung arbeitet, kann ein Plattenelement vorgesehen sein, das insbesondere eine ebene Oberfläche aufweist.

Das als Clip ausgebildete Halteelement kann in Weiterbildung zwei Schenkel aufweisen, die angenähert parallel verlaufen und so ausgebildet sind, dass sie, wenn das Halteelement mit dem elektronischen Bauteil verbunden ist, dieses zwischen sich einschließen. Die beiden Schenkel können dabei eine gewisse Vorspannung aufweisen, so dass sie klemmend an dem Bauelement festgelegt sind.

Zusätzlich zu der Klemmung kann auch vorgesehen sein, dass die beiden Schenkel in Angriffsrichtung des Greifers einen Formschluss bilden.

Bei dem elektronischen Bauteil handelt es sich um eine Spule, die wegen der Verwendung von im Querschnitt rundem Wicklungsdraht keine Angriffsfläche für einen Sauggreifer bildet. Die Spule weist einen Spulenkern auf und das Halteelement greift sowohl an dem Spulenkern als auch an mindestens einer Windung der Spulenwicklung an. Damit soll auch erreicht werden, dass bei ruckartigen Bewegungen des elektronischen Bauelements die Spule sich nicht von dem Spulenkern lösen kann.

Um hier einen Formschluss zu bilden, kann vorgesehen sein, dass die beiden Schenkel des Halteelements bis über die Mittelebene der Spule reichen, also bis zu einer Stelle, wo der Abstand der beiden Schenkel wieder kleiner geworden ist als in der Mittelebene selbst.

In nochmaliger Weiterbildung der Erfindung kann vorgesehen sein, dass das Halteelement auf seiner dem Bauelement zugewandten Innenseite eine Rippe aufweist. Diese Rippe kann insbesondere auch an den beiden Schenkeln ausgebildet sein. Auf diese Weise wird es möglich, dass die Rippe in eine Vertiefung zwischen zwei Drahtwindungen eingreift, so dass eine Formschluss auch in axialer Richtung einer Spule vorhanden ist.

Es kann vorgesehen sein, dass die Rippe sich über mehr als einen halben Umfang erstreckt. Sie kann auf diese Weise auch an dem Formschluss teilnehmen.

In nochmaliger Weiterbildung der Erfindung kann vorgesehen sein, dass die Rippe sich längs einer Schraubenlinie erstreckt. Sie kann auf diese Weise zwischen zwei Drahtwindungen auch über einen halben Umfang oder mehr eingreifen. Insbesondere kann dabei vorgesehen sein, dass die Rippe bis auf den Spulenkern reicht. Sie kann auf diese Weise auch einen Formschluss für den Spulenkern bilden.

Die Erfindung schlägt ebenfalls ein als Clip ausgebildetes Halteelement zur Anbringung an einem elektronischen Bauteil vor.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnung. Hierbei zeigen:
Figur 1 die Draufsicht auf ein elektronisches Bauteil in Form einer Spule;
Figur 2 die axiale Ansicht eines Halteelements;
Figur 3 die Ansicht des Halteelements der Figur 2 von rechts in Figur 2;
Figur 4 die Ansicht des Halteelements von unten in Figur 2 und Figur 3.

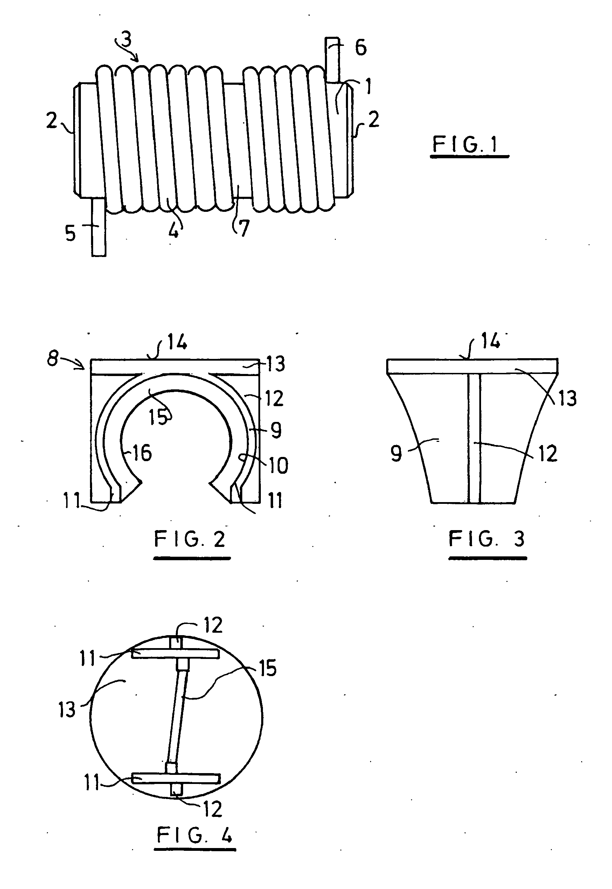

Die Figur 1 zeigt als Beispiel für ein elektronisches Bauelement eine Spule mit einem Spulenkern 1, beispielsweise aus Ferrit. Der Spulenkern 1 ist als kreiszylindrischer Stab ausgebildet. Er könnte auch einen anderen Querschnitt aufweisen. Der Stab enthält zwei ebene Stirnflächen 2. Der Spulenkern 1 ist von einer Spulenwicklung 3 umgeben, die eine Vielzahl von aneinander anliegenden Spulenwindungen 4 aufweist. Die beiden Enden 5, 6 der Spulenwicklung 3 sind tangential von dem Spulenkern 1 weggeführt. Die beiden Enden könnten auch länger sein, die Darstellung ist nur schematisch gedacht. Sie liegen in einer Ebene. Diese Ebene erstellt die Montageseite der Spule dar.

Die Windungen 4 der Spulenwicklung 3 sind an einer Stelle 7 so gewickelt, dass sie dort einen Abstand in Längsrichtung der Spule aufweisen. Dadurch ist eine Lücke gebildet, durch die hindurch ein Teil der Oberfläche des Spulenkerns 1 sichtbar ist.

Da ein solches elektronisches Bauelement von einem Sauggreifer nur schwer ergriffen werden könnte, wenn man von den ebenen Stirnflächen 2 absieht, schlägt die Erfindung zur Anbringung an dem elektronischen Bauelement ein Halteelement 8 vor, das in Figur 2 bis Figur 4 dargestellt ist. Dieses Halteelement ist als Clip ausgebildet und kann auf die Spule der Figur 1 quer zu deren Längsachse aufgeschnappt werden. Das Halteelement enthält einen mittleren angenähert einem Teil eines Zylindermantels entsprechenden Abschnitt 9, der eine der Außenform des elektronischen Bauteils entsprechende Innenform 10 aufweist. Im dargestellten Beispiel mit einer um einen kreiszylindrischen Kern 1 gewickelten Spule ist die Innenform des Abschnitts 9 daher ebenfalls kreiszylindrisch. In der Seitenansicht der Figur 2 erstreckt sich der Abschnitt 9 über etwa 3/4 eines Kreisbogens. Dadurch bildet das Halteelement zwei Schenkel 11, die beim Aufschnappen auf einen zylindrischen Körper klemmend an diesem festliegen und auch einen Formschluss bilden.

Zur Verstärkung weisen die beiden Schenkel 11 an der Außenseite des Mantelabschnitts 9 Stege 12 auf, die, wie man der Figur 3 entnehmen kann, mittig zwischen den beiden Enden angeordnet sind.

Auf der dem offenen Ende zwischen den Enden der beiden Schenkel 11 gegenüberliegenden Seite des Halteelements ist an diesem ein Plattenelement 13 angeformt. Dieses Plattenelement ist kreisförmig ausgebildet und enthält eine ebene Oberfläche 14, die als Angriffsstelle für einen Sauggreifer dienen kann. Die Angriffsstelle liegt auf der dem Zwischenraum zwischen den beiden Schenkel 11 abgewandten Seite des Halteelements acht.

Auf der Innenseite des Mantelabschnitts 9 verläuft zwischen den Schenkeln 11 eine nach innen gerichtete Rippe 15. Diese erstreckt sich ähnlich wie die beiden Schenkel 11 über etwa 3/4 eines Kreisbogens. Diese Rippe 15 weist eine derartige Radialerstreckung auf, dass der Durchmesser zwischen ihrer Innenkante 16 etwa dem Außendurchmesser des Spulenkerns 1 gleich ist.

Figur 4 zeigt eine Ansicht des Halteelements von unten in Figur 2 und Figur 3. Hieraus kann man entnehmen, dass die an der Innenseite des Mantelabschnitts 9 gebildete Rippe 15 längs einer Schraubenlinie verläuft. Sie kann also zwischen zwei Windungen 4 der Spulenwicklung 3 eingreifen, so dass ihre Innenkante 16 zur Anlage an der Oberfläche des Spulenkerns 1 gelangen kann.

Da sowohl die innere Rippe 15 als auch der Mantelabschnitt 9 sich über mehr als die Hälfte eines Kreisbogens erstrecken, bildet das Halteelement, wenn es auf die Spule der Figur 1 aufgeschnappt ist, sowohl einen in Auszugsrichtung wirkenden Formschluss an dem Spulenkern 1 als auch an der Spulenwicklung 3. Der Formschluss an dem Spulenkern 1 wird durch die innere Rippe 15 bewirkt, während der Formschluss an der Spulenwicklung 4 durch den Mantelabschnitt 9 bewirkt wird. Die Auszugsrichtung verläuft dabei senkrecht zu der Oberfläche 14 des Plattenelements 13. Gleichzeitig bildet die innere Rippe 15 einen Formschluss in axialer Richtung.

## Patentansprüche

1. Elektronisches zur automatischen Bestückung ausgebildetes Bauelement in Form einer Spule, mit
1.1 einem Spulenkern (1), einer Spulenwicklung (3) und mindestens zwei Anschlussenden (5, 6), sowie mit
1.2 einem Halteelement (8), das
1.3 eine Angriffsstelle für einen Greifer aufweist und
1.4 sowohl an dem Spulenkern (1) als auch an mindestens einer Windung (4) der Spulenwicklung (3) angreift und dadurch
1.5 in Angriffsrichtung des Greifers mindestens kraftschlüssig mit dem elektronischen Bauelement verbunden ist.

2. Bauelement nach Anspruch 1, bei dem das Halteelement (8) als Clip ausgebildet ist, der sich auf das Bauelement aufschnappen lässt.

3. Bauelement nach Anspruch 1 oder 2, bei dem die Angriffsstelle für den Greifer ein insbesondere ebenes Plattenelement (13) aufweist.

4. Bauelement nach einem der vorhergehenden Ansprüche, bei dem das Halteelement (8) zwei das Bauelement zwischen sich einschließende Schenkel (11) aufweist, die klemmend an dem Bauelement festgelegt sind.

5. Bauelement nach Anspruch 4, bei dem die beiden Schenkel (11) in Angriffsrichtung des Greifers einen Formschluss mit dem elektronischen Bauelement bilden.

6. Bauelement nach einem der vorhergehenden Ansprüche, bei dem die Schenkel (11) des Halteelements (8) bis über die Mittelebene der Spule reichen.

7. Bauelement nach einem der vorhergehenden Ansprüche, bei dem das Halteelement an dem Spulenkern (1) und an der Spulenwindung einen Formschluss bildet.

8. Bauelement nach einem der Ansprüche 2 bis 7, bei dem das Halteelement (8) auf seiner dem Bauelement zugewandten Innenseite eine Rippe (15) aufweist.

9. Bauelement nach Anspruch 8, bei dem die Rippe (15) sich über mehr als einen halben Umfang erstreckt.

10. Bauelement nach Anspruch 8 oder 9, bei dem die Rippe (15) sich längs einer Schraubenlinie erstreckt.

11. Bauelement nach Anspruch 10, bei dem die Rippe (15) bis auf den Spulenkern (1) reicht.

12. Halteelement für ein elektronisches Bauelement nach einem der vorhergehenden Ansprüche, ausgebildet als mit dem Bauelement durch Aufschnappen verbindbarer Clip.

13. Halteelement nach Anspruch 12, mit zwei das Bauelement zwischen sich einschließenden Schenkeln (11), die klemmend an dem Bauelement festlegbar sind.

## Claims

1. Electronic component designed for automatic insertion in the form of a coil, having
1.1 a coil core (1), a coil winding (3) and at least two contacting ends (5, 6), and having
1.2 a holding element (8) which
1.3 comprises a gripping site for a gripper, and
1.4 which engages with both the coil core (1) and with at least one turn (4) of the coil winding (3) and
1.5 is thereby connected to the electronic component with at least a force fit in the engagement direction of the gripper.

2. Component according to Claim 1, in which the holding element (8) is implemented as a clip which can be snapped onto the component.

3. Component according to Claim 1 or 2, in which the gripping site for the gripper comprises a plate element (13), in particular a flat plate element (13)

4. Component according to any one of the preceding claims, in which the holding element (8) comprises two limbs (11) enclosing the component between them, which are fixed onto the component with a clamping action.

5. Component according to Claim 4, in which the two limbs (11) form a positive-locking fit with the electronic component in the engagement direction of the gripper.

6. Component according to any one of the preceding claims, in which the limbs (11) of the holding element (8) extend over the central plane of the coil.

7. Component according to any one of the preceding claims, in which the holding element forms a positive-locking fit to the coil core (1) and to the coil turn.

8. Component according to any one of Claims 2 to 7, in which the holding element (8) comprises a rib (15) on its inner side facing the component.

9. Component according to Claim 8, in which the rib (15) extends over more than half of the circumference.

10. Component according to Claim 8 or 9, in which the rib (15) extends along a helical line.

11. Component according to Claim 10, in which the rib (15) extends as far as the coil core (1).

12. Holding element for a electronic component according to any one of the preceding claims, implemented as a clip that can be connected to the component by snapping on.

13. Holding element according to Claim 12, having two limbs (11) enclosing the component between them, which can be fixed to the component with a clamping action.

## Revendications

1. Composant électronique conçu à des fins de garnissage automatique sous forme d'une bobine, comportant
1.1 un noyau de bobine (1), un enroulement de bobine (3) et au moins deux extrémités de connexion (5, 6) ainsi que
1.2 un élément de retenue (8), qui
1.3 présente un emplacement d'intervention destiné à un organe de préhension et
1.4 vient en prise tant avec le noyau de bobine (1) qu'avec au moins un enroulement (4) de l'enroulement de bobine (3) et de cette manière
1.5 est relié dans la direction d'intervention de l'organe de préhension au moins par conjonction de force avec le composant électronique.

2. Composant selon la revendication 1, dans lequel l'élément de retenue (8) est réalisé comme un clip, qui peut être encliqueté sur le composant.

3. Composant selon la revendication 1 ou 2, dans lequel l'emplacement d'intervention destiné à l'organe de préhension présente notamment un élément de plaque (13) plat.

4. Composant selon une des revendications précédentes, dans lequel l'élément de retenue (8) présente deux pans (11) enserrant entre eux le composant, qui sont immobilisés par serrage sur le composant.

5. Composant selon la revendication 4, dans lequel les deux pans (11) forment dans la direction d'intervention de l'organe de préhension une conjonction de forme avec le composant électronique.

6. Composant selon une des revendications précédentes, dans lequel les pans (11) de l'élément de retenue (8) s'étendent jusqu'au-dessus du plan médian de la bobine.

7. Composant selon une des revendications précédentes, dans lequel l'élément de retenue forme une conjonction de forme sur le noyau de bobine (1) et sur l'enroulement de bobine.

8. Composant selon une des revendications 2 à 7, dans lequel l'élément de retenue (8) présente une nervure (15) sur son côté intérieur tourné vers le composant.

9. Composant selon la revendication 8, dans lequel la nervure (15) s'étend sur plus d'une demi-circonférence.

10. Composant selon la revendication 8 ou 9, dans lequel la nervure (15) s'étend le long d'une ligne de vissage.

11. Composant selon la revendication 10, dans lequel la nervure (15) s'étend jusqu'au noyau de bobine (1).

12. Elément de retenue pour un composant électronique selon une des revendications précédentes, réalisé comme un clip pouvant être relié au composant par encliquetage.

13. Elément de retenue selon la revendication 12, comportant deux pans (11) enserrant entre eux le composant, qui peuvent être immobilisés par serrage sur le composant.
